Europäisches Patentamt

European Patent Office

Office européen des brevets

(19)

(11) EP 0 429 220 B1

(12) EUROPEAN PATENT SPECIFICATION

(45) Date of publication and mention
of the grant of the patent:
17.07.1996 Bulletin 1996/29

(51) Int Cl.⁶: H03M 5/14, H03M 13/12

(21) Application number: 90312196.0

(22) Date of filing: 07.11.1990

(54) A method for coding a binary data string

Verfahren zur Kodierung einer binären Datenfolge

Méthode pour coder une chaîne de données binaires

(84) Designated Contracting States:
DE FR GB

(30) Priority: 13.11.1989 US 434970

(43) Date of publication of application:
29.05.1991 Bulletin 1991/22

(73) Proprietor: International Business Machines
Corporation
Armonk, N.Y. 10504 (US)

(72) Inventors:
• Karabed, Razmik
San Jose, CA 95120 (US)
• Siegel, Paul Howard
La Jolla, CA 92037 (US)

(74) Representative: Moss, Robert Douglas
IBM United Kingdom Limited
Intellectual Property Department
Hursley Park
Winchester Hampshire SO21 2JN (GB)

(56) References cited:
EP-A- 0 104 700          EP-A- 0 333 321
GB-A- 2 099 263          US-A- 4 775 985

## Description

Field of the Invention

This invention relates to a method of coding input strings of binary data over partial-response channels using maximum-likelihood sequence detection (PRML). More particularly, it relates to a method employing an improved rate 8/10 matched spectral null trellis code for PRML channels which provides block decoding, phase reversal invariance, decreased encoder/decoder complexity, and elimination of quasi-catastrophic sequences, while maintaining high coding gain.

Background of the Invention

The most pertinent prior art of which applicants are aware is their copending application, EPA 0333321. A coding method for a constrained system using a rate 8/10 code with spectral null at f=0 is described therein. While the coding method therein described operates very satisfactorily to achieve the stated objectives, it is sensitive to phase shifts in channel output signal. As a result, an inversion of the signal polarity can cause error propagation at the output of the decoder. Also, the code on occasion generates quasi-catastrophic sequences. These sequences represent more than one distinct path through the canonical state diagrams that describe sequences with spectral null constraints. Quasi-catastrophic sequences degrade the worst case coding gain and result in decoding delays.

GB 2099263-A describes a coding system in which each data word is assigned a set of codewords, each set comprising two or four words. Half the words in a set start with a binary "0", the others with a binary "1". The particular codeword that is selected from the set commences with the same bit as the last bit of the immediately preceding codeword.

There is a need for a method employing a matched spectral null (MSN) trellis code that: (1) is indifferent to 180-degree phase shifts in channel output signal (an important consideration in magnetic recording, where the state of the write driver and polarity of recording head leads may be unknown); (2) eliminates all quasi-catastrophic sequences; (3) eliminates the need for differential encoding/decoding circuits typically required for application of phase invariant codes; (4) decreases encoder/decoder complexity relative to the 8/10 code described in the above-cited application; and (5) achieves the foregoing without reduction in the coding gain.

Disclosure of the Invention

Accordingly, the invention provides a method for coding a binary data string for a partial-response channel having a transfer function with a spectral null at zero frequency to provide a code which is invariant to 180-degree phase shifts in the channel output signal and which may be decoded using a trellis decoder, said coding being performed using a finite-state machine having a plurality of pairs of states, with states in the same pair being termed complementary states, and a plurality of codewords each corresponding to a respective binary data byte, said method comprising the steps of:

(a) in said finite-state machine, encoding the binary data string into a string of binary codewords having a power spectrum value of zero for a frequency of zero, by generating for each data byte in said binary data string a codeword designated by said machine as corresponding to said data byte for the then current state of the machine, wherein the codeword for a given binary data byte in a first state in a pair is the complement of the codeword for the same binary data byte in the other state in the pair, and, for a given binary data byte, the next state following a given state in a pair and the next state following the other state in the pair are complementary states;
(b) and inputting said generated codewords into said partial response channel.

Preferably decoding is performed by a block decoder requiring no look-ahead to decode, and the code does not employ any quasi-catastrophic sequences from a spectrul null canonical state diagram. Preferably the method further comprises the step of preselecting the next state of said machine according to the value of the data byte and the current state.

Thus, according to the method, a binary data string is coded for a partial-response channel having a transfer function with a spectral null at zero frequency to provide a coding rate and an output which is invariant to 180-degree phase shifts in the channel output signal. A finite-state machine is created having a plurality of pairs of states and a plurality of codewords each corresponding to a respective binary data byte. The binary data string is encoded by said machine into a string of binary codewords having a power spectrum value of zero for a frequency of zero. In response to a data byte in the binary data string, one of two complementary codewords is generated from said binary codeword string. The said one complementary codeword is so decoded as to provide the same data byte output irrespective of which of said complementary codewords was generated. The next state of said machine is preselected according to the value of the data byte and current state, and the next state for one element of a pair is the complement of the next state for the other element of the same pair.

Brief Description of the Drawings

Fig. 1 is a block diagram of a recording system employing a trellis coding method according to the invention;

Fig. 2 depicts a seven-state subdiagram of the canonical diagram for binary sequences with spectral null at f=0;

Fig. 3 depicts the component of the second power of the diagram shown in Fig. 2;

Fig. 4 depicts an encoder for use in implementing the method of the invention;

Fig. 5 depicts a trellis structure for an MSN Viterbi detector; and

Fig. 6 depicts a block decoder for use in implementing the method of the invention.

Description of Preferred Embodiment

With reference to the drawings, an improved method is described for constructing a high rate 8/10 MSN trellis code for a partial response channel, such as a dicode (1-D) partial-response channel. The code can also be adapted to a class 4 $(1-D^2)$ partial-response channel by interleaving using the technique disclosed, for example, in the December 1988 issue of the IBM Technical Disclosure Bulletin at pp. 476 et seq. These are among the codes of greatest current interest in magnetic and optical data recording.

As described in EPA 0333321, an MSN trellis code spectrum is designed to have nulls at frequencies where the channel transfer function has a null, thereby providing improved coding gains and reduced Viterbi decoder complexity.

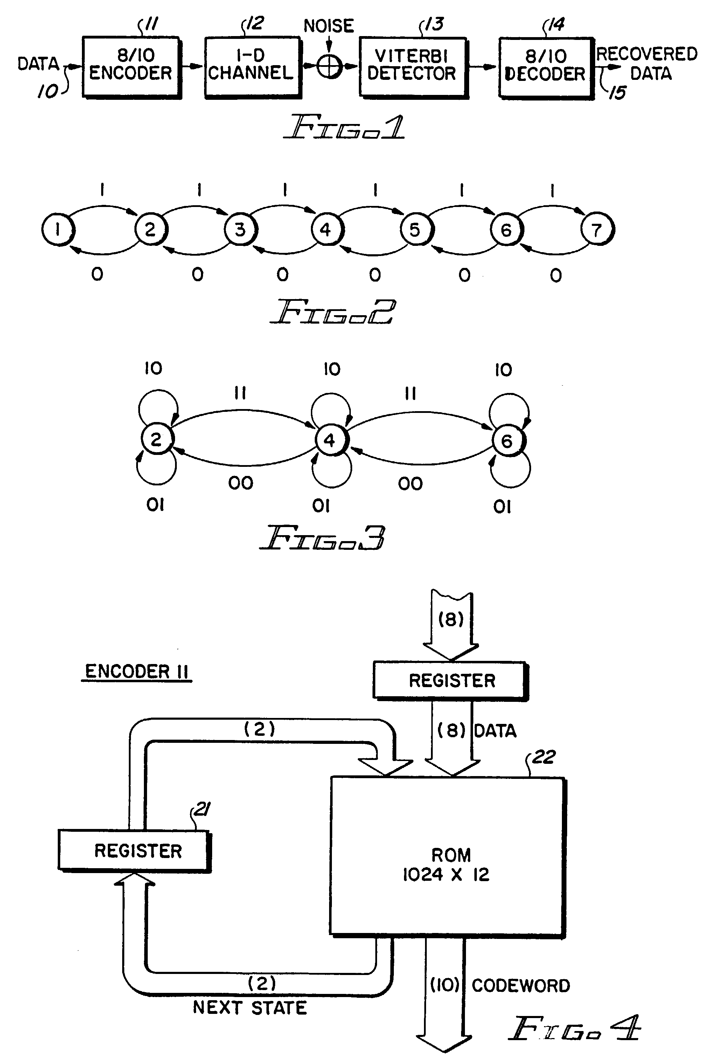

As illustrated in Fig. 1, input data, such as in the form of binary symbol strings, is transmitted from a bus 10 to a rate 8/10 finite-state-machine encoder 11. Encoder 11 produces a binary code symbol sequence that serves as input to a dicode (1-D) partial-response channel 12. This code has a power spectrum of zero for each frequency at which there is a zero in the transfer function of channel 12; i.e., the code sequences have spectral nulls that match those of the partial-response channel. A channel output sequence is generated by partial-response channel 12 and detected at the channel output by a Viterbi detector 13. This detector calculates the most probable code sequence from the channel output sequence. Detector 13 reduces computational and hardware requirements by tracking only the frequency spectral content of the channel output sequence, thereby producing a near maximum-likelihood estimate (or most probable code sequence) of the transmitted original data sequence supplied by the bus 10. A rate 10/8 decoder 14 then generates from the detected sequence the MSN code output data in a bus 15.

Table 1 shows the structure of the finite-state-machine encoder 11. As illustrated, the encoder 11 has four states designated by decimal numbers (0-3), and divided into two pairs 0,3 and 1,2. Within each pair, a given data byte will produce one of two complementary codewords, dependent upon which of the pair of states is the current state of the encoder. Data words are denoted by decimal numbers (0-255). Codewords are grouped into lists with similar properties (as hereinafter described) and designated by capital letters, with the size of the set indicated in parentheses. For example, F(10) denotes a list of 10 codewords (124, 188, 220, 236, 241, 242, 244, 248, 316 and 451, in decimal) designated by F. The notation $\bar{F}$ denotes the list of codewords which are obtained from the words in set F by bitwise complementing.

Table 1.

| Finite-State-Machine Encoder Structure | | | |
|---|---|---|---|
| State | Data | Next | Codeword |
| 0 | 0 - 99 | 3 | A(100) |
| 0 | 100 - 142 | 2 | B( 43) |
| 0 | 143 - 255 | 2 | C(113) |
| | | | |
| 1 | 0 - 9 | 2 | F( 10) |
| 1 | 10 - 99 | 2 | D( 90) |

Table 1.  (continued)

| Finite-State-Machine Encoder Structure | | | |
|---|---|---|---|
| State | Data | Next | Codeword |
| 1 | 100 - 142 | 0 | $E(43)$ |
| 1 | 143 - 255 | 0 | $\overline{C}(113)$ |
| | | | |
| 2 | 0 - 9 | 1 | $\overline{F}(10)$ |
| 2 | 10 - 99 | 1 | $\overline{D}(90)$ |
| 2 | 100 - 142 | 3 | $\overline{E}(43)$ |
| 2 | 143 - 255 | 3 | $C(113)$ |
| | | | |
| 3 | 0 - 99 | 0 | $\overline{A}(100)$ |
| 3 | 100 - 142 | 1 | $\overline{B}(43)$ |
| 3 | 143 - 255 | 1 | $\overline{C}(113)$ |

The codeword lists are characterized in a manner best explained by reference to the finite state transition diagram which describes the MSN constraint, which in this case corresponds to a spectral null at f=0.

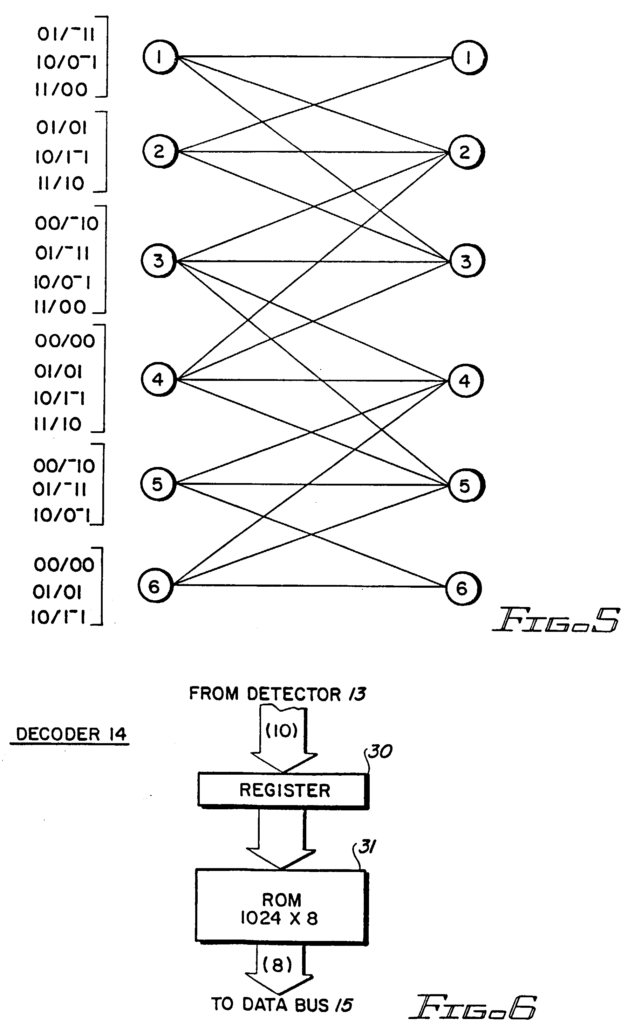

Fig. 2 shows a 7-state subdiagram of the canonical diagram for binary sequences with spectral null at f=0. The states are labelled 1 through 7. The paths in the diagram generate all binary sequences with digital sum variation (DSV) bounded by 6. The DSV corresponds to the maximum variation in the running digital sum value

$$\sum_{i=1}^{N} (-1)^{a_i}$$

achieved by any sequence $\underline{a}=a_1...a_N$ generated by the diagram.

The component of the second power of the diagram of Fig. 2, which contains states 2, 4 and 6, is shown in Fig. 3. The edges in Fig. 3 correspond to pairs of edges in Fig. 2 and are labelled by pairs of binary symbols. The lists of codewords used in the finite-state-machine encoder 11 are best described in terms of the diagram in Fig. 3. Fig. 3 is used to derive the Viterbi detector trellis structure illustrated in Fig. 5. All codewords are 10 bits in length and are generated by paths of length 5 in Fig. 3.

List A:    Consists of the 100 codewords generated by paths starting from state 2 and ending in state 6.

List B:    Consists of the 43 sequences generated by paths from state 2 to state 4 which also pass through state 6.

List C:    Consists of 113 of the 121 possible sequences generated by paths from state 2 to state 4 which do not pass through state 6.

List D:    Consists of the 90 codewords generated by paths which start and end at state 4 which also pass through state 2 but do not pass through state 6.

List E:    Consists of the 43 sequences generated by paths from state 4 to state 2 which also pass through state 6.

List F:    Consists of 10 of the 20 words which start and end at state 4 which also pass through both state 2 and state 6.

Table 2 gives a full description of the codeword lists, with the 10-bit words expressed in decimal. Lists are ordered left-to-right, row-by-row from top-to-bottom.

## Table 2.  Codeword Lists (in Decimal)

LIST A

```
351 367 375 379 381 382 415 431  439  443
445 446 463 471 475 477 478 487  491  493
494 499 501 502 505 506 607 623  631  635
637 638 671 687 695 699 701 702  719  727
731 733 734 743 747 749 750 755  757  758
761 762 799 815 823 827 829 830  847  855
859 861 862 871 875 877 878 883  885  886
889 890 911 919 923 925 926 935  939  941
942 947 949 950 953 954 967 971  973  974
979 981 982 985 986 995 997 998 1001 1002
```

LIST B

```
380 444   476 492 497 498 500 504 636 700
732 748   753 754 756 760 828 860 876 881
882 884   888 924 940 945 946 948 952 963
965 966   969 970 972 977 978 980 984 993
994 996 1000
```

LIST C

```
343 347 349 350 359 363 365 366 371 373
374 377 378 407 411 413 414 423 427 429
430 435 437 438 441 442 455 459 461 462
467 469 470 473 474 483 485 486 489 490
599 603 605 606 615 619 621 622 627 629
630 633 634 663 667 669 670 679 683 685
686 691 693 694 697 698 711 715 717 718
723 725 726 729 730 739 741 742 745 746
791 795 797 798 807 811 813 814 819 821
822 825 826 839 843 845 846 851 853 854
857 858 867 869 870 873 874 903 907 909
910 915 917
```

LIST D

```
 87  91  93  94 103 107 109 110 115 117
118 121 122 151 155 157 158 167 171 173
174 179 181 182 185 186 199 203 205 206
211 213 214 217 218 227 229 230 233 234
279 283 285 286 295 299 301 302 307 309
310 313 314 327 331 333 334 339 355 391
395 397 398 403 419 535 539 541 542 551
555 557 558 563 565 566 569 570 583 587
589 590 595 611 647 651 653 654 659 675
```

LIST E

240 368 432 449 450 452 456 464 480 624

688 705 706 708 712 720 736 773 774 777

778 780 785 786 788 792 801 802 804 808

816 833 834 836 840 848 864 897 898 900

904 912 928

LIST F

124 188 220 236 241 242 244 248 316 451

It will be noted that the rate 8/10 code described herein does not employ any of the quasi-catastrophic sequences of the canonical state diagram.

Fig. 4 illustrates a read only memory (ROM) implementation of finite-state-machine encoder 11 for the rate 8/10 trellis code. The ROM contents are derived directly from the right-most two columns of the finite-state-machine encoder Table 1. Encoder 11, as illustrated, comprises registers 20,21 and a ROM 22. The 8-bit input data string is delayed one machine cycle by register 20 and then output to ROM 22. ROM 22 also receives a 2-bit input from register 21, which constitutes the current state of encoder 11. The output from ROM 22 is a 10-bit codeword, 2 bits of which are recirculated via register 21 for denoting the next state.

Encoder 11 generates a binary code sequence that is input to the dicode partial-response channel 12. The output sequence generated by channel 12, affected by noise, is detected by Viterbi detector 13.

Fig. 5 shows the reduced complexity trellis structure of Viterbi detector 13 for the rate 8/10 MSN trellis code. Detector 13 is similar to that described in the above-cited copending application. It calculates most probable code sequence from the output sequence of channel 12. Detector 13 reduces computational and hardware requirements by tracking only the frequency spectral content of the channel output sequence, thereby to produce a near maximum-likelihood estimate (or most probable code sequence) of the original data sequence supplied via bus 10.

The trellis is derived from the diagram in Fig. 3, and represents the possible sequences at the output of dicode channel 12 when the channel inputs are generated by Fig. 3. The edges are labelled by $u_1u_2/v_1v_2$ where $u_1u_2$ are code symbols and $v_1v_2$ are channel output symbols. The free Euclidean distance of the trellis, $d^2_{free}$, is the minimum squared Euclidean distance between trellis-coded channel output sequences which start from the same state and remerge after a finite number of steps. It can be checked that $d^2_{free} = 4$, indicating a potential 3 dB gain over an uncoded dicode channel.

The Viterbi algorithm for the trellis in Fig. 5 is derived according to conventional methods such as described in the March 1973 issue of IEEE Proceedings at pp. 268-278. The survivor metric update rules are given in detail in Table 3. Survivor path extensions are determined on the basis of the metric update computation in the usual manner (Add-Compare-Select).

### Table 3. Algorithm: Metric Update Equations

$$M_{n+1}(1)=\min\{M_n(1)+2+2z_1-2z_2, M_n(2)+1-2z_2\}$$

$$M_{n+1}(2)=\min\{M_n(1)+1+2z_2, M_n(2)+2-2z_1+2z_2, M_n(3)+1+2z_1, M_n(4)\}$$

$$M_{n+1}(3)=\min\{M_n(1), M_n(2)+1-2z_1, M_n(3)+2+2z_1-2z_2, M_n(4)+1-2z_2\}$$

$$M_{n+1}(4)=\min\{M_n(3)+1+2z_2, M_n(4)+2-2z_1+2z_2, M_n(5)+1+2z_1, M_n(6)\}$$

$$M_{n+1}(5)=\min\{M_n(3), M_n(4)+1-2z_1, M_n(5)+2+2z_1-2z_2, M_n(6)+1-2z_2\}$$

$$M_{n+1}(6)=\min\{M_n(5)+1+2z_2, M_n(6)+2-2z_1+2z_2\}$$

where $M_n$ (j) is the survivor metric for state j at time n, where j varies from 1 to 6; and $z_1$ and $z_2$ represent two consecutive output signals from the channel.

According to an important feature of the invention, the rate 8/10 code is decoded with block decoder 14 that provides an output (see Table 4) which is the same for a codeword or its complement. Decoder 14 generates, from the detected sequence, the MSN code output data which is transmitted to bus 15.

Decoder 14 requires no look-ahead to decode the current codeword. For the current 10-bit codeword y, decoder 14 determines an 8-bit word w according to Table 4. The maximum error propagation due to a single bit error at the decoder input is therefore one byte.

### Table 4. Initial Look-up Table for Decoder 14

| | |
|---|---|
| A<br>—<br>A | 0 - 99 |
| B<br>—<br>B | 100 - 142 |
| C<br>—<br>C | 143 - 255 |

| | |
|---|---|
| $\dfrac{D}{\overline{D}}$ | 10 - 99 |
| $\dfrac{E}{\overline{E}}$ | 100 - 142 |
| $\dfrac{F}{\overline{F}}$ | 0 - 9 |

Decoder 14 may, for sake of illustration, be of the type shown in Fig. 6 for implementing the block decoder algorithm just described.

Decoder 14 comprises a register 30 which receives the 10-bit most probable code sequence codeword from detector 13. This codeword is transmitted to a 1024 X 8 bit read only memory (ROM) 31. Using look-up Table 4, ROM 31 decodes the 10-bit codeword into an 8-bit output. The 8-bit output of ROM 31 is transmitted to data bus 15. As a result of the structuring of the contents of ROM 31, the MSN code output data in bus 15 will be the same for a given codeword or its complement.

The method according to the invention has been described with reference to an 8/10 coding rate. However, it will be understood that this method may be used with codes with other coding rates.

## Claims

1. A method for coding a binary data string (10) for a partial-response channel (12) having a transfer function with a spectral null at zero frequency to provide a code which is invariant to 180-degree phase shifts in the channel output signal and which may be decoded using a trellis decoder, said coding being performed using a finite-state machine having a plurality of pairs of states, with states in the same pair being termed complementary states, and a plurality of codewords each corresponding to a respective binary data byte, said method comprising the steps of:

   a) in said finite-state machine, encoding the binary data string into a string of binary codewords having a power spectrum value of zero for a frequency of zero, by generating for each data byte in said binary data string a codeword designated by said machine as corresponding to said data byte for the then current state of the machine, wherein the codeword for a given binary data byte in a first state in a pair is the complement of the codeword for the same binary data byte in the other state in the pair, and, for a given binary data byte, the next state following a given state in a pair and the next state following the other state in the pair are complementary states;
   b) and inputting said generated codewords into said partial response channel.

2. The method of claim 1, wherein the next state of said finite-state machine is selected according to the value of the data byte and the current state.

3. The method of any preceding claim, wherein the code does not employ any quasi-catastrophic sequences from a spectral null canonical state diagram.

4. The method of any preceding claim, wherein the channel is a dicode (1-D) channel, and the output code has an 8/10 coding rate.

5. A method for coding a binary data string in accordance with any preceding claim, further comprising the step of decoding said generated codewords ,whereby said codewords may be decoded in such manner as to provide the same data byte output irrespective of which of said complementary codewords was generated.

6. The method of claim 5, wherein a table lookup is used to decode said codewords.

7. The method of claim 5 or 6, wherein the decoding is performed by a block decoder requiring no look-ahead to decode.

8. The method of any preceding claim, wherein the encoding and decoding is repeated for successive codewords.

**Patentansprüche**

1. Ein Verfahren zum Codieren einer binären Datenfolge (10) für einen Teilantwortkanal (12), der eine Übertragungsfunktion mit spektral Null bei Frequenz Null aufweist, um einen Code zu erzeugen, der für 180° Phasenverschiebung im Kanalausgangssignal invariant ist und der mit einem Gitter-Decodierer decodiert werden kann, wobei diese Codierung durch den Einsatz eines endlichen Automaten ausgeführt wird, der eine Vielzahl von Zustandspaaren, wobei die Zustände im gleichen Paar jeweils als komplementär bezeichnet werden, und eine Vielzahl von Codewörtern, die jedes einem betreffenden Binärdatenbyte entsprechen, aufweist, wobei das Verfahren die folgenden Schritte beinhaltet:

a) Codieren der Binärdatenfolge im endlichen Automat in eine Folge von Binärcodewörtern mit einem Leistungsspektrumwert Null für eine Frequenz Null, durch Generieren eines Codeworts für jedes Datenbyte in der Binärdatenfolge, das vom Automaten als entsprechend dem Datenbyte für den dann gängigen Zustand des Automaten gekennzeichnet wird, worin das Codewort für ein gegebenes binäres Datenbyte in einem ersten Zustand eines Paars das Komplement des Codeworts für das gleiche binäre Datenbyte im anderen Zustand des Paares ist, und, für ein gegebenes binäres Datenbyte, der nächste Zustand, der auf einen gegebenen Zustand in einem Paar folgt, und der nächste nachfolgende Zustand, der dem anderen Zustand im Paar folgt, komplementäre Zustände sind;
b) und Eingeben des generierten Codeworts in den Teilanwortkanal.

2. Verfahren gemäß Anspruch 1, in dem der nächste Zustand des endlichen Automaten gemäß dem Wert des Datenbyte und des augenblicklichen Zustands gewählt wird.

3. Verfahren gemäß einem beliebigen der vorstehenden Ansprüche, in dem der Code keine quasi-katastrophalen Folgen aus einem kanonischen Zustandsdiagramm mit Spektralnull anwendet.

4. Verfahren gemäß einem beliebigen der vorstehenden Ansprüche, in dem der Kanal ein Dicodekanal (1-D) ist und der Ausgangscode eine 8/10 Codierrate aufweist.

5. Ein Verfahren zum Codieren einer binären Datenfolge gemäß einem beliebigen der vorstehenden Ansprüche, der ferner den Schritt des Decodierens der generierten Codewörter aufweist, wobei diese Codewörter so decodiert werden können, daß sie den gleichen Datenbyteausgang erzeugen, unabhängig davon, welches der komplementären Codewörter generiert wurde.

6. Das Verfahren gemäß Anspruch 5, in dem das Nachschauen in einer Tabelle benutzt wird, die Codewörter zu decodieren.

7. Das Verfahren gemäß Anspruch 5 oder 6, in dem das Codieren durch einen Blockdecodierer geleistet wird, der zum Codieren keines Vorgriffs bedarf.

8. Das Verfahren gemäß einem beliebigen der vorstehenden Ansprüche, in dem das Codieren und Decodieren für nachfolgende Codewörter wiederholt wird.

**Revendications**

1. Procédé destiné à coder une chaîne de données binaires (10) destinée à un canal à réponse partielle (12) présentant une fonction de transfert avec un nul spectral à la fréquence zéro afin de procurer un code qui soit invariant pour des déphasages de 180° dans le signal de sortie de canal et qui peut être décodé en utilisant un décodeur en treillis, ledit codage étant réalisé en utilisant une machine à état fini présentant une pluralité de paires d'états, les états de la même paire étant appelés états complémentaires, et une pluralité de mots de code correspondant chacun à un octet de données binaires respectif, ledit procédé comprenant les étapes consistant à :

   (a) dans ladite machine à état fini, coder la chaîne de données binaires en une chaîne de mots de code binaires ayant une valeur zéro de spectre de puissance pour une fréquence zéro, en générant pour chaque octet de données dans ladite chaîne de données binaires un mot de code désigné par ladite machine comme correspondant audit octet de données pour l'état en cours de la machine, dans lequel le mot de code pour un octet de données binaires donné dans un premier état d'une paire est le complément du mot de code pour le même octet de données binaires dans l'autre état de la paire, et, pour un octet de données binaires donné, l'état suivant qui suit un état donné d'une paire et l'état suivant qui suit l'autre état de la paire, sont des états complémentaires,

   (b) et entrer lesdits mots de code générés dans ledit canal à réponse partielle.

2. Procédé selon la revendication 1, dans lequel l'état suivant de ladite machine à état fini est sélectionné selon la valeur de l'octet de données et de l'état en cours.

3. Procédé selon l'une quelconque des revendications précédentes, dans lequel le code n'utilise aucune des séquences quasicatastrophiques extraites d'un diagramme d'état canonique à nul spectral.

4. Procédé selon l'une quelconque des revendications précédentes, dans lequel le canal est un canal dicodé (1-D) et le code de sortie possède un taux de codage de 8/10.

5. Procédé destiné à coder une chaîne de données binaires en conformité avec l'une quelconque des revendications précédentes, comprenant en outre l'étape consistant à décoder lesdits mots de code générés, d'où il résulte que lesdits mots de code peuvent être décodés d'une manière telle qu'à procurer la même sortie d'octet de données indépendamment desquels desdits mots de code complémentaires ont été générés.

6. Procédé selon la revendication 5, dans lequel une consultation de table est utilisée pour décoder lesdits mots de code.

7. Procédé selon la revendication 5 ou la revendication 6, dans lequel le décodage est effectué par un décodeur de blocs ne nécessitant pas d'anticipation pour décoder.

8. Procédé selon l'une quelconque des revendications précédentes, dans lequel le codage et le décodage sont répétés pour des mots de code successifs.

*Fig. 1*

*Fig. 2*

*Fig. 3*

*Fig. 4*

01/⁻11
10/0⁻1
11/00

01/01
10/1⁻1
11/10

00/⁻10
01/⁻11
10/0⁻1
11/00

00/00
01/01
10/1⁻1
11/10

00/⁻10
01/⁻11
10/0⁻1

00/00
01/01
10/1⁻1

FIG.5

DECODER 14

FROM DETECTOR 13

(10)

REGISTER 30

ROM
1024 X 8 31

(8)

TO DATA BUS 15

FIG.6